# EUROPÄISCHE PATENTSCHRIFT

(11) **EP 4 172 640 B1**
(45) Veröffentlichungstag und Bekanntmachung des Hinweises auf die Patenterteilung: **16.07.2025**
(21) Anmeldenummer: 21733416.8
(22) Anmeldetag: 11.06.2021
(51) Int. Cl.: G01R 31/62

(54) **VERFAHREN UND SYSTEM ZUR BESTIMMUNG EINER KENNGRÖSSE**
METHOD AND SYSTEM FOR DETERMINING A CHARACTERISTIC VARIABLE
PROCÉDÉ ET SYSTÈME DE DÉTERMINATION D'UNE VARIABLE CARACTÉRISTIQUE

(30) Priorität: 14.07.2020 DE 102020118490
(43) Veröffentlichungstag der Anmeldung: 03.05.2023
(73) Patentinhaber: Maschinenfabrik Reinhausen GmbH, 93059 Regensburg (DE)
(72) Erfinder: LUPANDINA, Irina, 1090 Wien (AT); SCHRAMMEL, Michael, 1170 Wien (AT)
(86) Internationale Anmeldenummer: PCT/EP2021/065797
(87) Internationale Veröffentlichungsnummer: WO 2022/012828

(56) Entgegenhaltungen:
- US-A1- 2016 252 401
- ACHARYA SHRADDHA ET AL: "Life assessment of transformer using thermal models", 2017 INTERNATIONAL CONFERENCE ON ENERGY, COMMUNICATION, DATA ANALYTICS AND SOFT COMPUTING (ICECDS), IEEE, 1 August 2017 (2017-08-01), pages 3515 - 3520, XP033360427, DOI: 10.1109/ICECDS.2017.8390114

## Beschreibung

Die vorliegende Erfindung betrifft ein Verfahren zur Bestimmung einer Kenngröße, mit der für einen Bestimmungszeitpunkt eine thermische Belastung eines elektrischen Betriebsmittels abgebildet werden kann. Weiterhin betrifft die Erfindung ein Verfahren zur Netzsicherheitsberechnung in einem elektrischen Netz, das eine Mehrzahl von elektrischen Betriebsmitteln umfasst, ein Verfahren zur Betriebsführung eines elektrischen Betriebsmittels, ein System zur Bestimmung einer Kenngröße, ein System zur Netzsicherheitsberechnung in einem elektrischen Netz, das eine Mehrzahl von elektrischen Betriebsmitteln umfasst, sowie ein System zur Betriebsführung eines elektrischen Betriebsmittels.

Die Zuverlässigkeit von elektrischen Betriebsmitteln von elektrischen Netzen sowie die Belastbarkeit und Überbelastbarkeit hängt entscheidend von der Historie der Betriebsmittel und den Temperaturen ab, denen die elektrischen Betriebsmittel ausgesetzt waren. Beispielsweise hängt die Alterung der Festkörperisolierung und die dielektrischen Stärke der Isolierung von Transformatoren wesentlich von den Temperaturen ab, bei denen der Transformator betrieben wurde. Daher ist es für einen zuverlässigen Betrieb der elektrischen Betriebsmittel notwendig, relevante Temperaturen der Betriebsmittel und daraus deren thermische Auslastung bzw. deren thermischen Zustand zu bestimmen.

Beispielsweise wird der thermische Zustand eines Leistungstransformators durch die Top-Oil-Temperatur oder Hot-Spot-Temperatur beschrieben. Überschreiten die Temperaturen bestimmte Grenzwerte über bestimmte Zeiträume, altern die elektrischen Betriebsmittel überproportional schnell, wodurch die Netzsicherheit bzw. -stabilität beeinträchtigt werden kann.

Die relevanten Temperaturen können fortlaufend gemessen werden, wie beispielsweise die Top-Oil-Temperatur. Alternativ ist es auch möglich, Temperaturen aus anderen gemessenen Werten unter Verwendung von dynamischen Modellen vorherzusagen. Beispielsweise kann die Hot-Spot-Temperatur eines Transformators aus der gemessenen Top-Oil-Temperatur, der gemessenen Auslastung des Transformators sowie der Umgebungstemperatur des Transformators vorhergesagt werden.

Damit die Temperaturen beim Betrieb der elektrischen Betriebsmittel keine Grenzwerte überschreiten, werden bei der Planung der Auslastung der elektrischen Betriebsmittel maximale Auslastungen angenommen, unter denen die Temperaturen im angenommen Gleichgewichtszustand keine Grenzwerte überschreiten. Werden bei der Betriebsführung der elektrischen Betriebsmittel diese maximalen Auslastungen nicht überschritten, so kommt es auch zu keiner Überschreitung der kritischen Temperaturgrenzen und damit zu keiner vorzeitigen Alterung der elektrischen Betriebsmittel. Die maximal zulässigen Auslastungen werden auch bei der Berechnung der Netzsicherheit berücksichtigt, indem beispielsweise die Differenz zwischen der tatsächlichen Auslastung des elektrischen Betriebsmittels und der maximal zulässigen Auslastung des Betriebsmittels als Reserveauslastung angenommen wird, die beispielsweise bei unerwarteter hoher Nachfrage oder bei einem Ausfall anderer elektrische Betriebsmittel noch zur Verfügung steht.

In diesem Zusammenhang beschreibt US 2016/252401 A1 ein thermisches Überwachungs- und Vorhersagesystem für Transformatoren, das verwendet werden kann, um ein maximales Belastungslevel eines Transformators über einen zukünftigen Zeitraum vorherzusagen.

ACHARYA SHRADDHA ET AL: "Life assessment of transformer using thermal models" 2017 INTERNATIONAL CONFERENCE ON ENERGY, COMMUNICATION, DATA ANALYTICS AND SOFT COMPUTING, IEEE, 1.August 2017, Seiten 3515-3520, XP033360427, beschreibt Berechnungsmethoden zu Wicklungstemperatur und Alterungsverhalten als Grundlage für die Bestimmung des Lebensdauerverbrauchs von Transformatoren.

Ausgehend von diesem Hintergrund ist es, die Berücksichtigung des thermischen Zustands von elektrischen Betriebsmitteln bei der Steuerung von elektrischen Netzen, der Netzsicherheitsberechnung sowie der Steuerung des Betriebs von elektrischen Komponenten zu vereinfachen.

Die der Erfindung zugrundeliegende Aufgabe wird durch ein Verfahren nach den Anspruch 1, 8 oder 9 sowie durch Systeme nach den Ansprüchen 10 bis 12 gelöst. Bevorzugte Ausführungsformen sind Gegenstand der abhängigen Ansprüche.

In einem ersten Aspekt wird das der Erfindung zugrundliegende Problem durch ein Verfahren zur Bestimmung einer Kenngröße zur Abbildung einer thermischen Belastung eines elektrischen Betriebsmittels für einen Bestimmungszeitpunkt auf Grundlage einer Umgebungstemperatur des elektrischen Betriebsmittels zu dem Bestimmungszeitpunkt und eines ermittelten Wertes eines thermischen Betriebsparameters des Betriebsmittels zu dem Bestimmungszeitpunkt mittels eines ersten mathematischen Modells gelöst, das eine Abhängigkeit des thermischen Betriebsparameters des Betriebsmittels zu einem Berechnungszeitpunkt von der Umgebungstemperatur des elektrischen Betriebsmittels zu dem Berechnungszeitpunkt und der elektrischen Auslastung des Betriebsmittels zu dem Berechnungszeitpunkt beschreibt. Die Kenngröße für den Bestimmungszeitpunkt wird als die äquivalente elektrische Auslastung des elektrischen Betriebsmittels bestimmt, bei der das erste mathematische Modell unter Berücksichtigung der Umgebungstemperatur zu dem Bestimmungszeitpunkt den für den Bestimmungszeitpunkt ermittelten Wert des thermischen Betriebsparameters des elektrischen Betriebsmittels vorhersagt.

Mit anderen Worten wird im Rahmen des Verfahrens eine Kenngröße bestimmt, die die thermische Belastung des Betriebsmittels zu einem Bestimmungszeitpunkt abbildet und die beispielsweise bei der Netzsicherheitsberechnung oder bei der Betriebsführung des Betriebsmittels intuitiv verwendet und auf einfache Weise in bestehende Prozesse eingebunden werden kann. Beispiele für elektrische Betriebsmittel in Stromnetzten sind beispielsweise Transformatoren, Freileitungen, Erdkabel sowie Leistungsschalter.

Hierzu wird zunächst der Wert eines thermischen Betriebsparameters für den Bestimmungszeitpunkt, beispielsweise die Hot-Spot-Temperatur oder die Top-Oil-Temperatur eines Transformators, bestimmt. Verschiedene Möglichkeiten zur Bestimmung des thermischen Betriebsparameters, deren Eignung unter anderem von dem gewählten Zeitpunkt, für den die Kenngröße bestimmt werden soll, abhängen, sind Gegenstand bevorzugter Ausführungsformen. Weiterhin wird eine Umgebungstemperatur des elektrischen Betriebsmittels zu dem Bestimmungszeitpunkt bestimmt. Die Umgebungstemperatur kann beispielsweise gemessen oder Prognosedaten entnommen werden. Alternativ ist es auch möglich, einen vorbestimmten Wert für die Umgebungstemperatur zum Bestimmungszeitpunkt zu verwenden. Beispielsweise kann die Umgebungstemperatur zum Bestimmungszeitpunkt auf eine mittlere maximale Temperatur des Aufstellungsortes des Betriebsmittels gesetzt werden. Dabei ist es besonders bevorzugt, wenn die Umgebungstemperatur für den Bestimmungszeitpunkt auf einen Wert gesetzt wird, der für die Berechnung eines Nennstroms des elektrischen Betriebsmittels verwendet wurde. Der Wert des thermischen Betriebsparameters sowie die Umgebungstemperatur zu dem Bestimmungszeitpunkt sowie gegebenenfalls weitere Eingangsgrößen bilden die Grundlage der Bestimmung der Kenngröße mittels des ersten mathematischen Modells.

Dieses mathematische Modell beschreibt den bereits bestimmten thermischen Betriebsparameter, also beispielsweise die Hot-Spot-Temperatur eines Transformators, zu einem bestimmten Zeitpunkt in Abhängigkeit von der Umgebungstemperatur des elektrischen Betriebsmittels zu dem bestimmten Zeitpunkt sowie der elektrischen Auslastung des elektrischen Betriebsmittels zu dem bestimmten Zeitpunkt. Gegebenenfalls können auch weitere Eingangsgrößen verwendet werden. Das erste mathematische Modell ist somit ein statisches Modell, mit dem für gewöhnlich aus den mehreren Eingangsbetriebsparametern des elektrischen Betriebsmittels (hier: die Umgebungstemperatur und die elektrische Auslastung) ein weiterer Betriebsparameter berechnet werden kann, ohne dass dabei dynamische Effekte, wie sich ändernde Umgebungstemperaturen oder Auslastungen berücksichtigt wurden. Das erste mathematische Modell stellt somit einen Gleichgewichtszustand dar. Beispiele für geeignete mathematische Modelle, die als erstes mathematisches Modell für einen Transformator verwendet werden könne, sind die mathematischen Modelle aus IEC 60076-7, die die Hot-Spot-Temperatur und die Top-Oil-Temperatur eines Transformators im Gleichgewicht beschreiben.

Mittels des ersten mathematischen Modells wird die elektrische Auslastung des Betriebsmittels bestimmt, bei der das erste mathematische Modell unter Berücksichtigung der bekannten Umgebungstemperatur den zuvor bestimmten thermischen Betriebsparameter vorhersagt. Es wird somit aus einer bekannten Eingangsgröße sowie der bekannten Ausgangsgröße die fehlende Eingangsgröße ermittelt. Die so bestimmte elektrische Auslastung, bei der das erste mathematische Modell unabhängig von der tatsächlichen elektrischen Auslastung des elektrischen Betriebsmittels unter Berücksichtigung zumindest der Umgebungstemperatur den zuvor bestimmten elektrischen Betriebsparameter vorhersagen würde, wird als äquivalente elektrische Auslastung bezeichnet.

Die Kenngröße oder äquivalente elektrische Auslastung kann auf vorteilhafte Weise beispielsweise bei der Steuerung des elektrischen Betriebsmittels oder bei Netzsicherheitsberechnungen zu dem Bestimmungszeitpunkt anstelle der tatsächlichen elektrischen Auslastung verwendet werden. Die äquivalente elektrische Auslastung bildet den bestimmten Wert des thermischen Betriebsparameters und die Umgebungstemperaturen ab. So wird auf vorteilhafte Weise berücksichtigt, dass beispielsweise bei niedrigeren Umgebungstemperaturen höhere Auslastungen der elektrischen Betriebsmittel möglich sind, ohne dass es zu einer Überschreitung der Grenztemperaturen kommt.

Auch werden anders als bei herkömmlichen Berechnungen durch die Berücksichtigung der Kenngröße dynamische Effekte berücksichtigt. So reagiert das elektrische Betriebsmittel nach jeder Änderung der Umgebungstemperatur oder der Auslastung des elektrischen Betriebsmittels träge und wechselt nicht unmittelbar von einem stationären Zustand in den anderen. Der thermische Betriebsparameter wechselt somit bei einer beispielhaften Änderung der Auslastung des Betriebsmittels nicht sprunghaft von einem Wert auf den anderen, sondern kontinuierlich und verzögert. Beispielsweise folgt bei einem Anstieg der Auslastung der thermische Betriebsparameter nur langsam, so dass beispielsweise das Betriebsmittel kurzfristig deutlich stärker ausgelastet werden kann, ohne dass es zu einer Überschreitung von kritischen Temperaturen kommt.

In der erfindungsgemäßen Ausführungsform wird der ermittelte thermische Betriebsparameter des elektrischen Betriebsmittels zu dem Bestimmungszeitpunkt mittels eines zweiten mathematischen Modells ermittelt, das eine Abhängigkeit des thermischen Betriebsparameters des elektrischen Betriebsmittels von einem Verlauf einer Umgebungstemperatur des elektrischen Betriebsmittels, einem Verlauf einer elektrischen Auslastung des Betriebsmittels sowie eines Ausgangswertes für den thermischen Betriebsparameter beschreibt. Als Ausgangswert für den thermischen Betriebsparameter wird dabei ein Wert für den thermischen Betriebsparameter zu einem Ausgangszeitpunkt verwendet. Vorzugsweise wurde der Wert für den thermischen Betriebsparameter zum Ausgangszeitpunkt an dem elektrischen Betriebsmittel gemessen. Der Verlauf der Umgebungstemperatur beschreibt den Verlauf der Umgebungstemperatur des Betriebsmittels zwischen Ausgangszeitpunkt und Bestimmungszeitpunkt und der Verlauf der elektrischen Auslastung des Betriebsmittels beschreibt den Verlauf der elektrischen Auslastung des Betriebsmittels zwischen Ausgangszeitpunkt und Bestimmungszeitpunkt.

Mit anderen Worten wird in der erfindungsgemäßen Ausführungsform der thermische Betriebsparameter mittels eines zweiten mathematischen Modells berechnet, dass im Gegensatz zu dem ersten mathematischen Modell keinen stationären Zustand beschreibt. Vielmehr berücksichtigt das zweite mathematische Modell den Verlauf der Umgebungstemperatur und den Verlauf der Auslastung des Betriebsmittels ausgehend von einem Ausgangszeitpunkt, zu dem der thermische Betriebsparameter bekannt war, beispielsweise durch direkte Messung oder durch Berechnung aus anderen direkt gemessenen Werten. Beispiele für Modelle, die als zweites mathematisches Modell für einen Transformator verwendet werden können, ist das dynamische Modelle aus IEC 60076-7, mit dem die Hot-Spot-Temperatur und die Top-Oil-Temperatur eines Transformators berechnet werden können.

So kann auf vorteilhafte Weise aus einer einzelnen Messung des thermischen Betriebsparameters beispielsweise die Kenngröße für einen zukünftigen Zeitpunkt berechnet werden. Es ist aber auch denkbar, für einen Bestimmungszeitpunkt, der relativ zu dem Ausgangszeitpunkt in der Vergangenheit liegt, die Kenngröße zu bestimmen, um beispielsweise abschätzen zu können, um Auslastungen, die nach dem stationären Modell zu einer Überlastung und damit vorzeitigen Alterns des elektrischen Betriebsmittels geführt haben, auch tatsächlich zu einer Überlastung geführt haben.

Dabei wird im Rahmen des Verfahrens ein Verlauf der Kenngröße für einen Auswertungszeitraum, der eine Mehrzahl von Auswertungszeitpunkten umfasst, bestimmt, indem für jeden Auswertungszeitpunkt als Bestimmungszeitpunkt mittels des zweiten mathematischen Modells ein ermittelter Wert für den thermischen Betriebsparameter des elektrischen Betriebsmittels ermittelt wird und auf Grundlage des so ermittelten Wertes für den thermischen Betriebsparameter des elektrischen Betriebsmittels die Kenngröße für den jeweiligen Auswertungszeitpunkt als Bestimmungszeitpunkt mittels des ersten mathematischen Modells bestimmtwird.

Es ist weiterhin bevorzugt, den Verlauf der Kenngröße als zukünftig erwarteten Verlauf der Kenngröße ausgehend von einem aktuellen Zeitpunkt als Ausgangszeitpunkt über den Auswertungszeitraum zu bestimmen. Als Verlauf der Umgebungstemperatur wird dabei eine Prognose eines Verlaufs der Umgebungstemperatur des Betriebsmittels vom Ausgangszeitpunkt über den Auswertungszeitraum verwendet und als Verlauf der elektrischen Auslastung des Betriebsmittels eine Prognose eines Verlaufs der elektrischen Auslastung des Betriebsmittels vom Ausganszeitpunkt über den Auswertungszeitraum.

In der bevorzugten Ausführungsform wird somit nicht nur für einen einzelnen Bestimmungszeitpunkt die Kenngröße bestimmt, sondern für einen Auswertungszeitraum. Dies ist besonders vorteilhaft bei Berechnung der zukünftigen Netzsicherheit oder wenn der Betrieb des Betriebsmittels für einen zukünftigen Zeitraum geplant wird, da über den gesamten Zeitraum die äquivalente thermische Auslastung und damit in herkömmlichen Systemen dynamische Effekte berücksichtig werden können.

In einer weiteren bevorzugten Ausführungsform des Verfahrens wird der ermittelte Wert des thermischen Betriebsparameters des Betriebsmittels an dem Betriebsmittel gemessen oder aus einem oder mehreren gemessenen Betriebsparametern und/oder einer gemessenen Umgebungstemperatur des Betriebsmittels und/oder einer gemessenen Auslastung des Betriebsmittels berechnet. Mit anderen Worten kann der ermittelte Wert des thermischen Betriebsparameters in der bevorzugten Ausführungsform direkt gemessen werden. Alternativ kann der Wert unter Verwendung von anderen gemessenen Werten berechnet werden. Beispiele für gemessene Werte, aus denen der thermische Betriebsparameter ermittelt werden kann, sind die Umgebungstemperatur des Betriebsmittels, andere gemessene thermische Betriebsparameter und eine gemessene Auslastung.

Vorzugsweise wird für einen Bestimmungszeitpunkt als Kenngröße zur Abbildung der thermischen Belastung des elektrischen Betriebsmittels eine äquivalente elektrische Auslastung des elektrischen Betriebsmittels bestimmt, bei der eine Differenz zwischen dem mittels des ersten mathematischen Modells für den Bestimmungszeitpunkt bestimmten thermischen Betriebsparameter und dem thermischen Betriebsparameter des elektrischen Betriebsmittels zu dem Bestimmungszeitpunkt einen vorbestimmten Grenzwert unterschreitet, wobei zur Verringerung der Differenz ein Optimierungsalgorithmus und vorzugsweise ein gradientenbasierter Optimierungsalgorithmus wie das Newtonverfahren verwendet wird.

Mit anderen Worten wird bei einem ersten mathematischen Modell, das nicht analytisch für die elektrische Auslastung aufgelöst werden kann, die äquivalente thermische Auslastung mittels eines iterativen Näherungsverfahrens bestimmt.

Es ist weiterhin bevorzugt, für einen Bestimmungszeitpunkt eine Grenzkenngröße des elektrischen Betriebsmittels als diejenige elektrische Auslastung zu bestimmen, für die das erste mathematische Modell unter Berücksichtigung der Umgebungstemperatur des elektrischen Betriebsmittels zu dem Bestimmungszeitpunkt einen Wert für den thermischen Betriebsparameter des elektrischen Betriebsmittels vorhersagt, der einem Grenzwert des thermischen Betriebsparameters entspricht, den der Betriebsparameter nicht verletzen darf. Vorzugsweise hängt der Grenzwert von einer Betriebsart des elektrischen Betriebsmittels ab.

In der bevorzugten Ausführungsform werden neben der äquivalenten thermischen Auslastung zusätzlich Grenzkenngrößen bestimmt, indem mittels des ersten mathematischen Modells berechnet wird, welche Auslastung nach dem ersten mathematischen Modell dazu führen würde, dass bei der zum Bestimmungszeitpunkt vorliegenden Umgebungstemperatur ein zulässiger Grenzwert für den thermischen Betriebsparameter erreicht wurde. Auf diese Weise kann bei der Betriebsführung des elektrischen Betriebsmittels berücksichtig werden, dass niedrige Umgebungstemperaturen höhere Auslastungen des Betriebsmittels zulassen, bis der thermische Betriebsparameter einen Grenzwert überschreitet.

Weiter bevorzugt wird als Reservekenngröße eine Differenz der für einen Bestimmungszeitpunkt bestimmten Grenzkenngröße und der für den Bestimmungszeitpunkt bestimmten Kenngröße berechnet. Die Reservekenngröße kann auf vorteilhafte Weise bei Netzsicherheitsrechnungen berücksichtigt werden, da sie angibt, welche zusätzliche Last ein Betriebsmittel zum jeweiligen Bestimmungszeitpunkt aufnehmen kann, ohne das der thermische Betriebsparameter einen Grenzwert überschreitet und es zu einer beschleunigten Alterung des Betriebsmittels kommt.

In einer bevorzugten Ausführungsform werden als zweites mathematisches Modell in Abhängigkeit eines Verlaufs einer elektrischen Auslastung des elektrischen Betriebsmittels unterschiedliche mathematische Modelle verwendet. So können auf vorteilhafte Weise für unterschiedliche Lastverläufe unterschiedliche mathematische Modelle verwendet werden, da je nach Lastverlauf unterschiedliche Modelle besonders geeignet sein können, um die Entwicklung des thermischen Betriebsparameters zu beschreiben.

In einem weiteren Aspekt wird das der Erfindung zugrundeliegende Problem durch ein Verfahren zur Netzsicherheitsberechnung in einem elektrischen Netz, das eine Mehrzahl von elektrischen Betriebsmitteln umfasst, auf Grundlage eines erwarteten Verlaufs einer Auslastung der Mehrzahl von elektrischen Betriebsmitteln gelöst, wobei für zumindest ein elektrisches Betriebsmittel der Mehrzahl von elektrischen Betriebsmittel als erwarteter Verlauf der Auslastung des elektrischen Betriebsmittels ein mittels einer entsprechenden Ausführungsform des vorgehend beschriebenen Verfahrens bestimmter erwarteter Verlauf der Kenngröße für das zumindest eine elektrische Betriebsmittel verwendet wird.

Die Vorteile des Verfahrens zur Netzsicherheitsberechnung entsprechen den Vorteilen des dabei verwendeten Verfahrens zur Bestimmung der Kenngröße für das zumindest eine elektrische Betriebsmittel.

In einem weiteren Aspekt wird das der Erfindung zugrundeliegende Problem durch ein Verfahren zur Betriebsführung eines elektrischen Betriebsmittels gelöst, bei dem eine elektrische Auslastung des elektrischen Betriebsmittels zu einem Bestimmungszeitpunkt unter Berücksichtigung der für den Bestimmungszeitpunkt mittels einer entsprechenden Ausführungsform des vorgehend beschriebenen Verfahrens bestimmten Kenngröße angepasst wird.

Die Vorteile des Verfahrens zur Betriebsführung eines elektrischen Betriebsmittels entsprechen den Vorteilen des dabei verwendeten Verfahrens zur Bestimmung der Kenngröße für das zumindest eine elektrische Betriebsmittel.

In einem weiteren Aspekt wird das der Erfindung zugrundeliegende Problem durch ein System zur Bestimmung einer Kenngröße zur Abbildung einer thermischen Belastung eines elektrischen Betriebsmittels für einen Bestimmungszeitpunkt gelöst, wobei das System eine Datenverarbeitungsvorrichtung umfasst, die dazu konfiguriert ist, ein entsprechendes Verfahren nach einer der vorhergehenden Ausführungsformen auszuführen.

In einem weiteren Aspekt wird das der Erfindung zugrundeliegende Problem durch ein System zur Netzsicherheitsberechnung in einem elektrischen Netz, das eine Mehrzahl von elektrischen Betriebsmitteln umfasst, gelöst, wobei das System eine Datenverarbeitungseinrichtung umfasst, die dazu konfiguriert ist, ein entsprechendes Verfahren nach einer der vorhergehenden Ausführungsformen auszuführen.

In einem weiteren Aspekt wird das der Erfindung zugrundeliegende Problem durch ein System zur Betriebsführung eines elektrischen Betriebsmittels gelöst, wobei das System eine Datenverarbeitungseinheit umfasst, die dazu konfiguriert ist, ein entsprechendes Verfahren nach einer der vorhergehenden Ausführungsformen auszuführen.

Die Vorteile der verschiedenen Ausführungsformen der Systeme entsprechen jeweils den Vorteilen der Verfahren, zu deren Ausführung die Datenverarbeitungseinheiten der Systeme jeweils konfiguriert sind. Zudem können die im Rahmen der Beschreibung der Verfahren dargestellten Ausgestaltungen des Verfahrens auch auf das jeweilige System übertragen werden.

Nachfolgend werden bezugnehmend auf die Zeichnung mehrere Ausführungsbeispiele eines Verfahrens zur Bestimmung einer Kenngröße sowie eines Systems, in dem die entsprechenden Verfahren ausgeführt werden können, näher beschrieben. Dabei zeigt
- Figur 1: eine schematische Darstellung eines Ausführungsbeispiels eines Teils eines elektrischen Netzes mit einer Mehrzahl von elektrischen Betriebsmitteln,
- Figur 2: eine schematische Darstellung eines Ausführungsbeispiels einer Datenverarbeitungsvorrichtung und
- Figur 3: eine schematische Darstellung eines Ausführungsbeispiels eines Verfahrens zur Bestimmung einer Kenngröße zur Abbildung einer thermischen Belastung eines elektrischen Betriebsmittels.

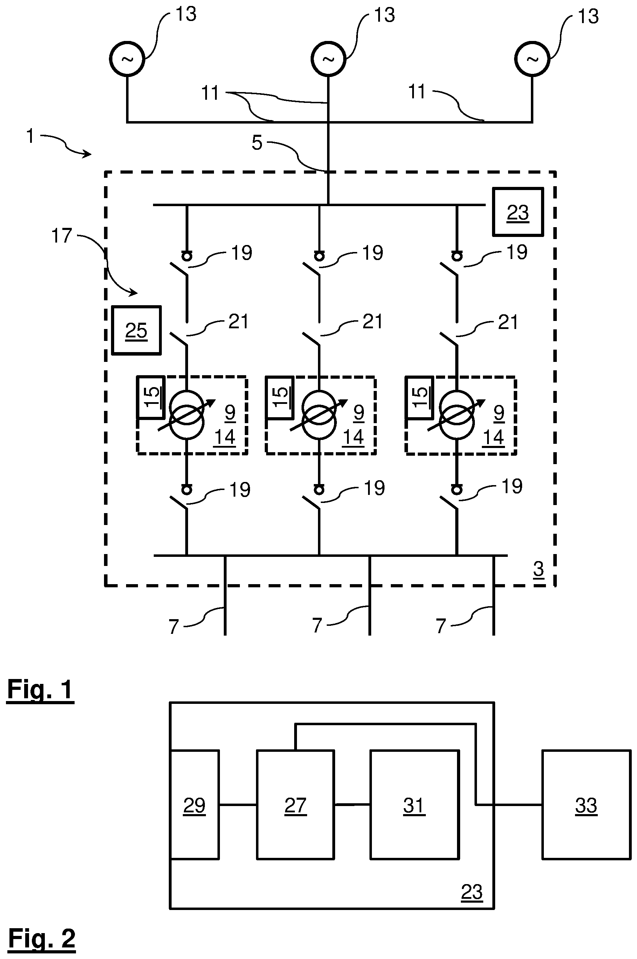

Figur 1 zeigt zunächst eine Ausführungsform eines Teils eines elektrischen Netzes oder Stromnetzes in Form eines Umspannwerks 3 und mehrerer Erzeuger 13. Das Umspannwerk 3 umfasst einen Versorgungseingang 5, mehrere Abgänge 7 sowie mehrere elektrische Betriebsmittel oder Komponenten 9. In Figur 1 sind nur drei Abgänge 7 und nur drei elektrische Komponenten 9 dargestellt, das Umspannwerk 3 kann jedoch mehr oder weniger Abgänge und elektrische Betriebsmittel umfassen.

Der Versorgungseingang 5 ist über Freileitungen 11, die ebenfalls elektrische Betriebsmittel darstellen, mit den drei Erzeugern 13 verbunden, bei denen es sich beispielsweise um Windenergieanlagen handeln kann. Über weitere, mit den Abgängen 7 verbundene Leitungen, die in Figur 1 nicht dargestellt sind, ist das Umspannwerk 3 mit ebenfalls nicht dargestellten Lasten oder Verbrauchern verbunden. Das elektrische Netz 1 kann weitere Umspannwerke, weitere Erzeuger und weitere Verbraucher umfassen.

Bei den in dem Ausführungsbeispiel dargestellten elektrischen Betriebsmitteln 9 des Stromnetzes 1 handelt es sich um Transformatoren 14. An jedem Transformator 14 ist eine Überwachungseinheit 15 angeordnet, die Betriebsparameter und Kennzahlen des Transformators 14 ermittelt und verwaltet. Beispielsweise ermittelt die Überwachungseinheit 15 unter Verwendung eines nicht dargestellten Sensors als einen thermischen Betriebsparameter eine Top-Oil-Temperatur des Transformators 14 und bestimmt aus dieser unter Verwendung eines geeigneten mathematischen Modells sowie weiterer Betriebsparameter und Kennzahlen des Transformators 14 eine Hot-Spot-Temperatur in Windungen von Spulen des Transformators 14. Die Überwachungseinheit 15 erfasst zudem den Strom, der durch den Transformator 14 fließt. Weiterhin werden in der Überwachungseinheit 15 zeitlich unveränderliche Kenndaten wie Nennleistung und Baujahr des Transformators und historische Daten wie beispielsweise DGA Analysen, Inbetriebnahmetests und Ergebnisse von visuellen Inspektionen vorgehalten.

Für jedes elektrische Betriebsmittel 9 sind Grenzwerte definiert, die im Betrieb nicht überschritten werden dürfen. Diese Grenzwerte können in den Überwachungseinheiten hinterlegt sein. Beispielsweise können Grenzwerte für die Top-Oil-Temperatur und die Hot-Spot-Temperatur hinterlegt sein.

Das Umspannwerk 3 umfasst zudem eine Mehrzahl von Leistungsschaltern 19 und Trennschaltern 21, zusammenfassend als Schalter 19, 21 bezeichnet, die zusammen eine Schaltanordnung 17 bilden. Die Schalter 19, 21 sind ebenfalls elektrische Betriebsmittel.

Schließlich umfasst das Umspannwerk 3 und damit das Stromnetz 1 eine zentrale Datenverarbeitungseinrichtung, Datenverarbeitungseinheit oder Datenverarbeitungsvorrichtung 23, die mit den Überwachungseinheiten 15 und auch mit einer Steuerung 25 des Umspannwerks 3, die insbesondere die Stellungen der Schalter 19, 21 steuert, verbunden ist. Die zentrale Datenverarbeitung 23 ist weiterhin mit externen Datenquellen (nicht dargestellt) verbundenen, auf die nachfolgend noch näher eingegangen werden wird. Die Verbindungen der Datenverarbeitungseinheit 23 sind in Figur 1 nicht dargestellt, um die Darstellung übersichtlich zu halten.

Figur 2 zeigt schematisch den Aufbau einer beispielhaften Datenverarbeitungsvorrichtung 23, wie der in Figur 1 gezeigten. Diese umfasst eine zentrale Recheneinheit oder CPU 27, eine Kommunikationseinheit 29 und einen Speicher 31. Weiterhin zeigt Figur 2 eine Benutzerschnittstelle 33, wie zum Beispiel ein Bildschirm und ein oder mehrere Eingabegeräte, über die ein Nutzer mit der zentralen Datenverarbeitungseinheit 23 interagieren kann und über die dem Nutzer Ergebnisse von Berechnungen angezeigt werden können. Die Benutzerschnittstelle 33 ist nicht notwendigerweise Teil der zentralen Datenverarbeitungseinheit 23. Über die Kommunikationseinheit 29 kann die zentrale Datenverarbeitungseinheit 23 unter anderem mit der Steuerung 25, den Überwachungseinheiten 15 sowie weiteren Datenquellen (nicht dargestellt) kommunizieren, d.h., Daten empfangen und senden.

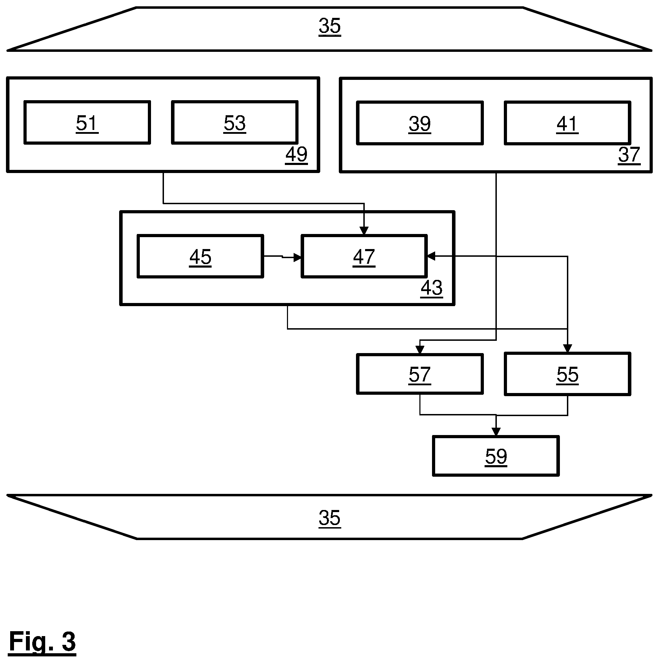

Schließlich zeigt Figur 3 ein Flussdiagramm eines Ausführungsbeispiels eines Verfahrens, mit dem für ein elektrisches Betriebsmittel 9, 11, 19, 21 eine Kennzahl bestimmt wird, die eine thermische Belastung des Betriebsmittels 9, 11, 19, 21 abbildet. In dem dargestellten Ausführungsbeispiel ist das Betriebsmittel 9 ein Transformator 14.

Das in Figur 3 gezeigte Verfahren ist dafür ausgelegt, die Kennzahl für einen Zeitraum von beispielsweise 24 Stunden oder 48 Stunden zu bestimmen. Dieser Zeitraum wird als Auswertungs- oder Prognosezeitraum bezeichnet, über den der Verlauf der Kenngröße ermittelt wird. Der Auswertungszeitraum umfasst regelmäßig eine Vielzahl von Auswertungszeitpunkten, die beispielsweise gleichmäßig im 15-Minuten-Takt über den Auswertungszeitraum verteilt werden können. Das Verfahren kann aber auch verwendet werden, um die Kennzahl nur für einen einzelnen Zeitpunkt zu bestimmten, beispielsweise in dem der Auswertungszeitraum auf diesen einen Zeitpunkt eingeschränkt wird.

Wie durch die beiden Trapeze 35 angegeben wird, werden die nachfolgend dargestellten Verfahrensschritte für alle Auswertungszeitpunkte des Prognosezeitraums durchgeführt. Die Verfahrensschritte können für jeden Auswertungszeitpunkt wiederholt werden, also sequentiell abgearbeitet werden. Es ist aber auch möglich, einige oder alle Verfahrensschritte parallel zueinander abzuarbeiten. Die konkrete Abfolge der Schritte und inwieweit einzelne Schritte für jeden Auswertungszeitpunkt wiederholt, für alle Auswertungszeitpunkte parallel abgearbeitet oder gegebenenfalls für alle Auswertungszeitpunkte nur einmal durchgeführt werden müssen, ist dem Fachmann aus seinem allgemeinen Fachwissen bekannt.

Nachfolgend wird die Durchführung des Verfahrens so beschrieben, als wenn alle Verfahrensschritte für jeden Auswertungszeitpunkt wiederholt werden. Der Auswertungszeitpunkt, für den das Verfahren aktuell durchgeführt wird, wird nachfolgend als Bestimmungszeitpunkt bezeichnet.

In dem vorliegenden Ausführungsbeispiel wird zunächst in einem ersten Verfahrensschritt 37 eine Umgebungstemperatur des Transformators 14 bestimmt. Die Umgebungstemperatur kann, wenn der Bestimmungszeitpunkt die aktuelle Zeit ist, in einer Umgebungstemperaturmessung 39 mittels eines Temperatursensors gemessen werden. Alternativ kann die Umgebungstemperatur auch aus einer Datenbank abgelesen werden, in der Umgebungstemperaturdaten vorgehalten werden (zweiter Schritt 41). Dies kann insbesondere dann erforderlich sein, wenn der Bestimmungszeitpunkt in der Zukunft oder in der Vergangenheit liegt.

Umgebungstemperaturen für die Zukunft und auch aktuelle Temperaturen können beispielsweise Prognosedaten oder Wetterberichten entnommen werden, die von externen Dienstleistern zur Verfügung gestellt werden. Umgebungstemperaturen für Bestimmungszeitpunkte, die in der Vergangenheit liegen, können beispielsweise einer Datenbank entnommen werden, die mit eigenen Messwerten befüllt ist oder auch durch externe Dienstleister zur Verfügung gestellt werden.

Die Umgebungstemperaturen können dem Verfahren auch durch eine an dem Transformator 14 angeordnete Überwachungseinheit 15 bereitgestellt werden.

In einem dritten Schritt 43 wird ein thermischer Betriebsparameter des Transformators 14 zu dem Bestimmungszeitpunkt bestimmt oder ermittelt. Der thermische Betriebsparameter ist in dem vorliegenden Ausführungsbeispiel die Top-Oil-Temperatur oder die Hot-Spot-Temperatur des Transformators. Der thermische Betriebsparameter kann beispielsweise in einer Betriebsparametermessung 45 gemessen werden, insbesondere wenn der Bestimmungszeitpunkt der aktuelle Zeitpunkt ist und der Betriebsparameter, wie die Top-Oil-Temperatur unmittelbar gemessen werden kann. Wird die Hot-Spot-Temperatur als thermischer Betriebsparameter verwendet, die nur aufwendig direkt gemessen werden kann, kann der thermische Betriebsparameter auch alternativ aus anderen gemessenen Betriebsparameters abgeleitet werden. Die Hot-Spot-Temperatur kann beispielweise aus der Umgebungstemperatur, der gemessenen Top-Oil-Temperatur und weiteren Messwerten, wie der Auslastung des Transformators 14, berechnet werden.

Alternativ kann der thermische Betriebsparameter auch in einer Betriebsparameterberechnung 47 mittels eines mathematischen Modells berechnet werden. Dies kann insbesondere für in der Zukunft liegende Bestimmungszeitpunkte bedeuten, dass der Wert des thermischen Betriebsparameters mittels eines zweiten mathematischen Modells berechnet wird. Das zweite mathematische Modell beschreibt dynamisch die Entwicklung des thermischen Betriebsparameters ausgehend von einem Ausgangszeitpunkt, für den der thermische Betriebsparameter bekannt ist, unter Berücksichtigung der Entwicklung der Umgebungstemperatur und der Auslastung des Transformators 14. In Abhängigkeit vom Verlauf der Auslastung des Transformators 14 können unterschiedliche zweite mathematische Modelle verwendet werden. Beispielsweise kann ein zweites mathematisches Modell plötzliche Laständerungen besonders gut beschreiben und ein weiteres zweites Modell gleichmäßige Laständerungen über lange Zeiträume.

Liegt der Bestimmungszeitpunkt in der Vergangenheit, kann der thermische Betriebsparameter ebenfalls mittels der Betriebsparameterberechnung 47 berechnet werden oder einer Datenbank entnommen werden. Schließlich kann das Bestimmen des thermischen Betriebsparameters auch erfolgen, in dem eine an dem Transformator 14 angeordnete Überwachungseinheit 15 diesen auf Abfrage des Verfahrens bereitstellt.

Die bei der Betriebsparameterberechnung 47 benötigte elektrische Auslastung des elektrischen Betriebsmittels 9, 11, 19, 21 wird in einem vierten Schritt 49 bestimmt. Wird die aktuelle elektrische Auslastung benötigt, kann sie in einer Auslastungsmessung 51 bestimmt werden. Andernfalls kann die elektrische Auslastung in einer Datenbankabfrage 53 ermittelt werden, bei der entweder aufgezeichnete Messwerte für in der Vergangenheit liegende Bestimmungszeitpunkt oder prognostizierte elektrische Auslastungen für die Zukunft abgefragt werden. Insbesondere prognostizierte Messwerte können auch aus externen Datenquellen abgefragt werden.

Die elektrische Auslastung kann dem Verfahren auch durch eine an dem Transformator 14 angeordnete Überwachungseinheit 15 bereitgestellt werden, die die zuvor beschriebenen Schritte übernimmt.

In einem fünften Schritt 55 wird schließlich aus der im ersten Schritt 37 erhaltenen Umgebungstemperatur und dem im dritten Schritt erhaltenen thermischen Betriebsparameter, der Hot-Spot-Temperatur oder der Top-Oil-Temperatur des Transformators 14, die Kennzahl für die thermische Auslastung bestimmt. Hierzu wird anhand eines ersten mathematischen Modells, dass die Abhängigkeit des thermischen Betriebsparameters im Gleichgewicht, d.h., in einem stationären Zustand, von der Umgebungstemperatur und der elektrischen Auslastung beschreibt, diejenige äquivalente elektrische Auslastung bestimmt, bei der das erste mathematische Modell in Abhängigkeit von der Umgebungstemperatur den zuvor bestimmten thermischen Betriebsparameter vorhersagt.

Zur Bestimmung der äquivalenten elektrischen Auslastung kann insbesondere ein Optimierungsalgorithmus, wie das Newtonverfahren, bei dem iterativ eine Lösung für das mathematische Modell gesucht wird. Auch dieser Verfahrensschritt kann, wie alle vorhergehenden Verfahrensschritte, in einer Überwachungseinheit 15 durchgeführt werden.

In einem sechsten Schritt 57 wird aus der im ersten Schritt 37 erhaltenen Umgebungstemperatur und einem oder mehreren für den thermischen Betriebsparameter bekannten Grenzwerten eine äquivalente elektrische Grenzauslastung als Grenzkenngröße bestimmt, in dem in Abhängigkeit von der für den Bestimmungszeitpunkt ermittelten Umgebungstemperatur die elektrische Auslastung ermittelt wird, für die das erste mathematische Modell für den thermischen Betriebsparameter den Grenzwert vorhersagt.

Schließlich wird in einem abschließenden siebten Schritt 59 als Reservekenngröße die Differenz aus der Grenzkenngröße und der Kenngröße bestimmt, die für den Bestimmungszeitpunkt angibt, um wieweit die elektrische Auslastung des Transformators 14 erhöht werden kann, ohne dass es zu einer Überlastung des Transformators 14 kommt.

Werden die vorstehenden Schritte für eine Vielzahl von aufeinanderfolgenden Bestimmungszeitpunkten durchgeführt, also über längere Auswertungszeiträume, so können die bestimmten Kenngrößen, Grenzkenngrößen und Reservekenngröße zu Verläufen zusammengefasst werden, die insbesondere bei der Bewertung von zurückliegenden Ereignissen oder für die Planung der zukünftigen Steuerung des elektrischen Netzes 1 und des jeweiligen elektrischen Hilfsmittels hilfreich sein können. Die bisher beschriebenen Verfahrensschritte werden in diesem Fall im Rahmen eines Verfahrens zur Steuerung des elektrischen Betriebsmittels oder eines Verfahrens zu Netzsicherheitsberechnung verwendet werden, bei dem die Berechnungen vorzugsweise für eine Vielzahl von elektrischen Betriebsmitteln durchgeführt werden.

Das beschriebene Verfahren zur Berechnung der Kenngröße kann, wie bereits erwähnt, vollständig auf einer Überwachungseinheit 15 durchgeführt werden, die in diesem Fall mit einem Prozessor oder Datenverarbeitungseinrichtung ausgestattet ist und ein System zur Bestimmung einer Kennzahl bildet. Alternativ ist auch eine verteilte Berechnung der Kennzahlen denkbar, bei der ein Teil der Verfahrensschritte von einer Überwachungseinheit 15 durchgeführt werden und ein weiterer Teil von einer zentralen Datenverarbeitungseinrichtung 23, die auch Teil einer Cloud sein kann.

Selbiges gilt auch für die entsprechenden Verfahren zur Netzsicherheitsberechnung und zur Betriebsführung eines elektrischen Betriebsmittels und den entsprechenden Systemen, bei denen die jeweiligen Datenverarbeitungsvorrichtungen ebenfalls durch die Überwachungseinheiten, eine zentrale Datenverarbeitungseinheit oder einer Cloud bzw. Mischformen von diesen gebildet werden können.

Die beispielhaften Ausführungsformen der Verfahren und der Systeme ermöglichen auf die Berücksichtigung der thermischen Auslastung von elektrischen Betriebsmitteln auf intuitive Weise und erlaubt es insbesondere die einfache Einbindung der neuen Verfahren in bestehende Systeme, die lediglich die elektrische Auslastung der elektrischen Betriebsmittel berücksichtigen, ohne dass diese verändert werden müssen.

### Bezugszeichenliste

- 1: Stromnetz, elektrisches Netz
- 3: Umspannwerk
- 5: Versorgungseingang
- 7: Abgang
- 9: elektrische Betriebsmittel, Komponenten
- 11: Freileitungen, elektrische Betriebsmittel
- 13: Erzeuger
- 14: Transformator
- 15: Überwachungseinheit
- 17: Schaltanordnung
- 19: Leistungsschalter, elektrische Betriebsmittel
- 21: Trennschalter, elektrische Betriebsmittel
- 23: zentrale Datenverarbeitungsvorrichtung, -einrichtung, -einheit
- 25: Steuerung des Umspannwerks
- 27: CPU
- 29: Kommunikationseinheit
- 31: Speicher
- 33: Benutzerschnittstelle
- 35: Trapeze
- 37: erster Schritt
- 39: Umgebungstemperaturmessung
- 41: zweiter Schritt
- 43: dritter Schritt
- 45: Betriebsparametermessung
- 47: Betriebsparameterberechnung
- 49: vierter Schritt
- 51: Auslastungsmessung
- 53: Datenbankabfrage
- 55: fünfter Schritt
- 57: sechster Schritt
- 59: siebter Schritt

## Patentansprüche

1. Verfahren zur Bestimmung einer Kenngröße zur Abbildung einer thermischen Belastung eines elektrischen Betriebsmittels (9, 11, 19, 21) für einen Bestimmungszeitpunkt auf Grundlage einer Umgebungstemperatur des elektrischen Betriebsmittels (9, 11, 19, 21) zu dem Bestimmungszeitpunkt und eines ermittelten Wertes eines thermischen Betriebsparameters des Betriebsmittels zu dem Bestimmungszeitpunkt mittels eines ersten mathematischen Modells, das eine Abhängigkeit des thermischen Betriebsparameters des Betriebsmittels zu einem Berechnungszeitpunkt von der Umgebungstemperatur des elektrischen Betriebsmittels (9, 11, 19, 21) zu dem Berechnungszeitpunkt und der elektrischen Auslastung des Betriebsmittels (9, 11, 19, 21) zu dem Berechnungszeitpunkt beschreibt,
wobei die Kenngröße für den Bestimmungszeitpunkt als die äquivalente elektrische Auslastung des elektrischen Betriebsmittels (9, 11, 19, 21) bestimmt wird, bei der das erste mathematische Modell unter Berücksichtigung der Umgebungstemperatur zu dem Bestimmungszeitpunkt den für den Bestimmungszeitpunkt ermittelten Wert des thermischen Betriebsparameters des elektrischen Betriebsmittels vorhersagt.
wobei der ermittelte thermische Betriebsparameter des elektrischen Betriebsmittels (9, 11, 19, 21) zu dem Bestimmungszeitpunkt mittels eines zweiten mathematischen Modells ermittelt wird, das eine Abhängigkeit des thermischen Betriebsparameters des elektrischen Betriebsmittels (9, 11, 19, 21) von einem Verlauf einer Umgebungstemperatur des elektrischen Betriebsmittels (9, 11, 19, 21), einem Verlauf einer elektrischen Auslastung des Betriebsmittels (9, 11, 19, 21) sowie eines Ausgangswertes für den thermischen Betriebsparameter beschreibt,
wobei als Ausgangswert für den thermischen Betriebsparameter ein Wert für den thermischen Betriebsparameter zu einem Ausgangszeitpunkt verwendet wird, wobei der Wert für den thermischen Betriebsparameter vorzugsweise zum Ausgangszeitpunkt an dem elektrischen Betriebsmittel (9, 11, 19, 21) gemessen wurde,
wobei der Verlauf der Umgebungstemperatur den Verlauf der Umgebungstemperatur des Betriebsmittels (9, 11, 19, 21) zwischen Ausgangszeitpunkt und Bestimmungszeitpunkt beschreibt und
wobei der Verlauf der elektrischen Auslastung des Betriebsmittels (9, 11, 19, 21) den Verlauf der elektrischen Auslastung des Betriebsmittels (9, 11, 19, 21) zwischen Ausgangszeitpunkt und Bestimmungszeitpunkt beschreibt, **dadurch gekennzeichnet, dass**
ein Verlauf der Kenngröße für einen Auswertungszeitraum, der eine Mehrzahl von Auswertungszeitpunkten umfasst, bestimmt wird, indem für jeden Auswertungszeitpunkt als Bestimmungszeitpunkt mittels des zweiten mathematischen Modells ein ermittelter Wert für den thermischen Betriebsparameter des elektrischen Betriebsmittels (9, 11, 19, 21) ermittelt wird und auf Grundlage des so ermittelten Wertes für den thermischen Betriebsparameter des elektrischen Betriebsmittels (9, 11, 19, 21) die Kenngröße für den jeweiligen Auswertungszeitpunkt als Bestimmungszeitpunkt mittels des ersten mathematischen Modells bestimmt wird.

2. Verfahren nach Anspruch 1, wobei der Verlauf der Kenngröße als zukünftig erwarteter Verlauf der Kenngröße ausgehend von einem aktuellen Zeitpunkt als Ausgangszeitpunkt über den Auswertungszeitraum bestimmt wird,
wobei als Verlauf der Umgebungstemperatur eine Prognose eines Verlaufs der Umgebungstemperatur des Betriebsmittels (9, 11, 19, 21) vom Ausgangszeitpunkt über den Auswertungszeitraum verwendet wird und
wobei als Verlauf der elektrischen Auslastung des Betriebsmittels (9, 11, 19, 21) eine Prognose eines Verlaufs der elektrischen Auslastung des Betriebsmittels (9, 11, 19, 21) vom Ausganszeitpunkt über den Auswertungszeitraum verwendet wird.

3. Verfahren nach Anspruch 1, wobei der ermittelte Werte des thermischen Betriebsparameters des Betriebsmittels (9, 11, 19, 21) an dem Betriebsmittel (9, 11, 19, 21) gemessen wird oder
wobei der ermittelte Wert des thermischen Betriebsparameters des Betriebsmittels (9, 11, 19, 21) aus einem oder mehreren gemessenen Betriebsparametern und/oder einer gemessenen Umgebungstemperatur des Betriebsmittels (9, 11, 19, 21) und/oder einer gemessenen Auslastung des Betriebsmittels (9, 11, 19, 21) berechnet wird.

4. Verfahren nach einem der vorhergehenden Ansprüche, wobei für einen Bestimmungszeitpunkt als Kenngröße zur Abbildung der thermischen Belastung des elektrischen Betriebsmittels (9, 11, 19, 21) eine äquivalente elektrische Auslastung des elektrischen Betriebsmittels (9, 11, 19, 21) bestimmt wird, bei der eine Differenz zwischen dem mittels des ersten mathematischen Modells für den Bestimmungszeitpunkt bestimmten thermischen Betriebsparameter und dem thermischen Betriebsparameter des elektrischen Betriebsmittels (9, 11, 19, 21) zu dem Bestimmungszeitpunkt einen vorbestimmten Grenzwert unterschreitet, wobei zur Verringerung der Differenz ein Optimierungsalgorithmus und vorzugsweise ein gradientenbasierter Optimierungsalgorithmus wie das Newtonverfahren verwendet wird.

5. Verfahren nach einem der vorhergehenden Ansprüche, wobei für einen Bestimmungszeitpunkt eine Grenzkenngröße des elektrischen Betriebsmittels (9, 11, 19, 21) als diejenige elektrische Auslastung bestimmt wird, für die das erste mathematische Modell unter Berücksichtigung der Umgebungstemperatur des elektrischen Betriebsmittels zu dem Bestimmungszeitpunkt einen Wert für den thermischen Betriebsparameter des elektrischen Betriebsmittels (9, 11, 19, 21) vorhersagt, der einem Grenzwert des thermischen Betriebsparameters entspricht, den der Betriebsparameter nicht verletzen darf,
wobei der Grenzwert vorzugsweise von einer Betriebsart des elektrischen Betriebsmittels (9, 11, 19, 21) abhängt.

6. Verfahren nach Anspruch 4, wobei als Reservekenngröße eine Differenz der für einen Bestimmungszeitpunkt bestimmten Grenzkenngröße und der für den Bestimmungszeitpunkt bestimmten Kenngröße berechnet wird.

7. Verfahren nach einem der vorhergehenden Ansprüche, wobei als zweites mathematisches Modell in Abhängigkeit eines Verlaufs einer elektrischen Auslastung des elektrischen Betriebsmittels (9, 11, 19, 21) unterschiedliche mathematische Modelle verwendet werden.

8. Verfahren zur Netzsicherheitsberechnung in einem elektrischen Netz, das eine Mehrzahl von elektrischen Betriebsmitteln (9, 11, 19, 21) umfasst, auf Grundlage eines erwarteten Verlaufs einer Auslastung der Mehrzahl von elektrischen Betriebsmitteln (9, 11, 19, 21), wobei für zumindest ein elektrisches Betriebsmittel (9, 11, 19, 21) der Mehrzahl von elektrischen Betriebsmittel (9, 11, 19, 21) als erwarteter Verlauf der Auslastung des elektrischen Betriebsmittels (9, 11, 19, 21) ein nach Anspruch 2 oder nach einem der Ansprüche 4 bis 7, sofern abhängig von Anspruch 2, bestimmter erwarteter Verlauf der Kenngröße für das zumindest eine elektrische Betriebsmittel (9, 11, 19, 21) verwendet wird.

9. Verfahren zur Betriebsführung eines elektrischen Betriebsmittels (9, 11, 19, 21), bei dem eine elektrische Auslastung des elektrischen Betriebsmittels (9, 11, 19, 21) zu einem Bestimmungszeitpunkt unter Berücksichtigung der für den Bestimmungszeitpunkt nach einem der Ansprüche 1 bis 7 bestimmten Kenngröße angepasst wird.

10. System zur Bestimmung einer Kenngröße zur Abbildung einer thermischen Belastung eines elektrischen Betriebsmittels (9, 11, 19, 21) für einen Bestimmungszeitpunkt, wobei das System eine Datenverarbeitungsvorrichtung (23) umfasst, die dazu konfiguriert ist, ein Verfahren nach einem der Ansprüche 1 bis 7 auszuführen.

11. System zur Netzsicherheitsberechnung in einem elektrischen Netz, das eine Mehrzahl von elektrischen Betriebsmitteln (9, 11, 19, 21) umfasst, wobei das System eine Datenverarbeitungseinrichtung (23) umfasst, die dazu konfiguriert ist, ein Verfahren nach Anspruch 8 auszuführen.

12. System zur Betriebsführung eines elektrischen Betriebsmittels (9, 11, 19, 21), wobei das System eine Datenverarbeitungseinheit (23) umfasst, die dazu konfiguriert ist, ein Verfahren nach Anspruch 9 auszuführen.

## Claims

1. Method for determining a parameter for mapping a thermal load of an electrical equipment (9, 11, 19, 21) for a determination time on the basis of an ambient temperature of the electrical equipment (9, 11, 19, 21) at the determination time and a determined value of a thermal operating parameter of the equipment at the determination time by means of a first mathematical model, which describes a dependence of the thermal operating parameter of the equipment at a calculation time on the ambient temperature of the electrical equipment (9, 11, 19, 21) at the calculation time and the electrical utilization of the equipment (9, 11, 19, 21) at the calculation time,
wherein the parameter for the time of determination is determined as the equivalent electrical utilization of the electrical equipment (9, 11, 19, 21), in which the first mathematical model predicts the value of the thermal operating parameter of the electrical equipment determined for the time of determination, taking into account the ambient temperature at the time of determination.
wherein the determined thermal operating parameter of the electrical equipment (9, 11, 19, 21) is determined at the time of determination by means of a second mathematical model which describes a dependence of the thermal operating parameter of the electrical equipment (9, 11, 19, 21) on a course of an ambient temperature of the electrical equipment (9, 11, 19, 21), a course of an electrical utilization of the equipment (9, 11, 19, 21) and an initial value for the thermal operating parameter,
wherein a value for the thermal operating parameter at an initial point in time is used as the initial value for the thermal operating parameter, wherein the value for the thermal operating parameter was preferably measured at the electrical equipment (9, 11, 19, 21) at the initial point in time,
wherein the course of the ambient temperature describes the course of the ambient temperature of the equipment (9, 11, 19, 21) between the initial time and the time of determination, and
wherein the course of the electrical utilization of the equipment (9, 11, 19, 21) describes the course of the electrical utilization of the equipment (9, 11, 19, 21) between the initial time and the determination time, **characterized in that**
a course of the characteristic variable is determined for an evaluation period, which comprises a plurality of evaluation times, **in that** a determined value for the thermal operating parameter of the electrical equipment (9, 11, 19, 21) is determined for each evaluation time as a determination time by means of the second mathematical model and the characteristic variable for the respective evaluation time as a determination time is determined by means of the first mathematical model on the basis of the value thus determined for the thermal operating parameter of the electrical equipment (9, 11, 19, 21).

2. Method according to claim 1, wherein the course of the characteristic variable is determined as the expected future course of the characteristic variable starting from a current point in time as the starting point in time over the evaluation period,
wherein a forecast of a course of the ambient temperature of the equipment (9, 11, 19, 21)from the initial time over the evaluation period is used as the course of the ambient temperature, and
wherein a forecast of a course of the electrical utilization of the equipment (9, 11, 19, 21) from the starting time over the evaluation period is used as the course of the electrical utilization of the equipment (9, 11, 19, 21).

3. Method according to claim 1, wherein the determined value of the thermal operating parameter of the equipment (9, 11, 19, 21) is measured on the equipment (9, 11, 19, 21), or
wherein the determined value of the thermal operating parameter of the equipment (9, 11, 19, 21) is calculated from one or more measured operating parameters and/or a measured ambient temperature of the equipment (9, 11, 19, 21) and/or a measured utilization of the equipment (9, 11, 19, 21).

4. Method according to one of the preceding claims, wherein an equivalent electrical utilization of the electrical equipment (9, 11, 19, 21) is determined for a determination time as a parameter for mapping the thermal load of the electrical equipment (9, 11, 19, 21), in which a difference between the thermal operating parameter determined by means of the first mathematical model for the time of determination and the thermal operating parameter of the electrical equipment (9, 11, 19, 21) at the time of determination falls below a predetermined limit value, an optimization algorithm and preferably a gradientbased optimization algorithm such as the Newton method being used to reduce the difference.

5. Method according to one of the preceding claims, wherein for a determination time a limit parameter of the electrical equipment (9, 11, 19, 21) is determined as that electrical utilization for which the first mathematical model, taking into account the ambient temperature of the electrical equipment at the determination time, predicts a value for the thermal operating parameter of the electrical equipment (9, 11, 19, 21) which corresponds to a limit value of the thermal operating parameter which the operating parameter must not violate,
wherein the limit value preferably depends on an operating mode of the electrical equipment (9, 11, 19, 21).

6. Method according to claim 4, wherein a difference between the limiting characteristic determined for a time of determination and the characteristic determined for the time of determination is calculated as the reserve characteristic.

7. Method according to one of the preceding claims, wherein different mathematical models are used as the second mathematical model depending on a course of an electrical utilization of the electrical equipment (9, 11, 19, 21).

8. Method for network security calculation in an electrical network, which comprises a plurality of electrical equipment (9, 11, 19, 21), on the basis of an expected course of a utilization of the plurality of electrical equipment (9, 11, 19, 21), wherein for at least one electrical equipment (9, 11, 19, 21) of the plurality of electrical equipment (9, 11, 19, 21) an expected course of the utilization of the electrical equipment (9, 11, 19, 21) according to claim 2 or according to one of claims 4, 11, 19, 21) is calculated as the expected course of the utilization of the electrical equipment (9, 11, 19, 21), 21) of the plurality of electrical equipment (9, 11, 19, 21), an expected course of the characteristic variable for the at least one electrical equipment (9, 11, 19, 21) determined according to claim 2 or according to one of claims 4 to 7, if dependent on claim 2, is used as the expected course of the utilization of the electrical equipment (9, 11, 19, 21).

9. Method for operating an electrical equipment (9, 11, 19, 21), in which an electrical utilization of the electrical equipment (9, 11, 19, 21) is adapted at a determination time, taking into account the characteristic determined for the determination time according to one of claims 1 to 7.

10. A system for determining a characteristic for representing a thermal load of an electrical equipment (9, 11, 19, 21) for a determination time, the system comprising a data processing device (23) configured to perform a method according to any one of claims 1 to 7.

11. A system for network security calculation in an electrical network comprising a plurality of electrical equipment (9, 11, 19, 21), the system comprising a data processing means (23) configured to carry out a method according to claim 8.

12. A system for operating an electrical equipment (9, 11, 19, 21), the system comprising a data processing unit (23) configured to carry out a method according to claim 9.

## Revendications

1. Procédé de détermination d'une grandeur caractéristique pour représenter une charge thermique d'un moyen d'exploitation électrique (9, 11, 19, 21) pour un instant de détermination sur la base d'une température ambiante du moyen d'exploitation électrique (9, 11, 19, 21) à l'instant de détermination et d'une valeur déterminée d'un paramètre de fonctionnement thermique du moyen d'exploitation à l'instant de détermination au moyen d'un premier modèle mathématique, qui décrit une dépendance du paramètre de fonctionnement thermique du moyen d'exploitation à un instant de calcul par rapport à la température ambiante du moyen d'exploitation électrique (9, 11, 19, 21) à l'instant de calcul et à la charge électrique du moyen d'exploitation (9, 11, 19, 21) à l'instant de calcul,
la grandeur caractéristique pour le moment de détermination étant déterminée comme la charge électrique équivalente du moyen d'exploitation électrique (9, 11, 19, 21), pour laquelle le premier modèle mathématique prédit, en tenant compte de la température ambiante au moment de détermination, la valeur du paramètre de fonctionnement thermique du moyen d'exploitation électrique déterminée pour le moment de détermination.
le paramètre de fonctionnement thermique déterminé du moyen d'exploitation électrique (9, 11, 19, 21) étant déterminé au moment de la détermination au moyen d'un deuxième modèle mathématique qui décrit une dépendance du paramètre de fonctionnement thermique du moyen d'exploitation électrique (9, 11, 19, 21) par rapport à une évolution d'une température ambiante du moyen d'exploitation électrique (9, 11, 19, 21), une évolution d'une charge électrique du moyen d'exploitation (9, 11, 19, 21) ainsi qu'une valeur de départ pour le paramètre de fonctionnement thermique,
dans lequel on utilise comme valeur initiale pour le paramètre de fonctionnement thermique une valeur pour le paramètre de fonctionnement thermique à un moment initial, la valeur pour le paramètre de fonctionnement thermique ayant été mesurée de préférence au moment initial sur le moyen d'exploitation électrique (9, 11, 19, 21),
l'évolution de la température ambiante décrivant l'évolution de la température ambiante du moyen d'exploitation (9, 11, 19, 21) entre le moment de départ et le moment de détermination et
l'évolution de la charge électrique du moyen d'exploitation (9, 11, 19, 21) décrivant l'évolution de la charge électrique du moyen d'exploitation (9, 11, 19, 21) entre le moment initial et le moment de détermination, **caractérisé en ce que**
une évolution de la grandeur caractéristique est déterminée pour une période d'évaluation qui comprend une pluralité de moments d'évaluation, en déterminant pour chaque moment d'évaluation, en tant que moment de détermination, au moyen du deuxième modèle mathématique, une valeur déterminée pour le paramètre de fonctionnement thermique du moyen de fonctionnement électrique (9, 11, 19, 21) et en déterminant, sur la base de la valeur ainsi déterminée pour le paramètre de fonctionnement thermique du moyen de fonctionnement électrique (9, 11, 19, 21), la grandeur caractéristique pour le moment d'évaluation respectif en tant que moment de détermination, au moyen du premier modèle mathématique.

2. Procédé selon la revendication 1, dans lequel l'évolution de la grandeur caractéristique est déterminée en tant qu'évolution future attendue de la grandeur caractéristique en partant d'un moment actuel comme moment initial sur la période d'évaluation,
une prévision d'une évolution de la température ambiante du moyen d'exploitation (9, 11, 19, 21) à partir de l'instant initial sur la période d'évaluation étant utilisée comme évolution de la température ambiante, et
dans lequel on utilise comme courbe de la charge électrique du moyen d'exploitation (9, 11, 19, 21) un pronostic d'une courbe de la charge électrique du moyen d'exploitation (9, 11, 19, 21) à partir de l'instant de départ sur la période d'évaluation.

3. Procédé selon la revendication 1, dans lequel la valeur déterminée du paramètre de fonctionnement thermique du moyen d'exploitation (9, 11, 19, 21) est mesurée sur le moyen d'exploitation (9, 11, 19, 21) ou
la valeur déterminée du paramètre de fonctionnement thermique du moyen de fonctionnement (9, 11, 19, 21) étant calculée à partir d'un ou de plusieurs paramètres de fonctionnement mesurés et/ou d'une température ambiante mesurée du moyen de fonctionnement (9, 11, 19, 21) et/ou d'une charge mesurée du moyen de fonctionnement (9, 11, 19, 21).

4. Procédé selon l'une des revendications précédentes, dans lequel, pour un instant de détermination, une charge électrique équivalente du moyen d'exploitation électrique (9, 11, 19, 21) est déterminée en tant que paramètre caractéristique pour représenter la charge thermique du moyen d'exploitation électrique (9, 11, 19, 21), dans laquelle une différence entre le paramètre de fonctionnement thermique déterminé au moyen du premier modèle mathématique pour le moment de détermination et le paramètre de fonctionnement thermique du moyen d'exploitation électrique (9, 11, 19, 21) au moment de détermination est inférieure à une valeur limite prédéterminée, un algorithme d'optimisation et de préférence un algorithme d'optimisation basé sur le gradient comme le procédé Newton étant utilisé pour réduire la différence.

5. Procédé selon l'une des revendications précédentes, dans lequel, pour un instant de détermination, une grandeur caractéristique limite du moyen d'exploitation électrique (9, 11, 19, 21) est déterminée comme étant la charge électrique pour laquelle le premier modèle mathématique prédit, en tenant compte de la température ambiante du moyen d'exploitation électrique à l'instant de détermination, une valeur pour le paramètre d'exploitation thermique du moyen d'exploitation électrique (9, 11, 19, 21) qui correspond à une valeur limite du paramètre d'exploitation thermique que le paramètre d'exploitation ne doit pas dépasser,
la valeur limite dépendant de préférence d'un mode de fonctionnement du moyen d'exploitation électrique (9, 11, 19, 21).

6. Procédé selon la revendication 4, dans lequel on calcule comme grandeur caractéristique de réserve une différence entre la grandeur caractéristique limite déterminée pour un moment de détermination et la grandeur caractéristique déterminée pour le moment de détermination.

7. Procédé selon l'une des revendications précédentes, dans lequel on utilise comme deuxième modèle mathématique différents modèles mathématiques en fonction d'une évolution d'une charge électrique du moyen d'exploitation électrique (9, 11, 19, 21).

8. Procédé de calcul de la sécurité du réseau dans un réseau électrique qui comprend une pluralité de moyens d'exploitation électriques (9, 11, 19, 21), sur la base d'une évolution attendue d'une charge de la pluralité de moyens d'exploitation électriques (9, 11, 19, 21), dans lequel, pour au moins un moyen d'exploitation électrique (9, 11, 19, 21), on calcule une évolution attendue de la charge du moyen d'exploitation électrique (9, 11, 19, 21), 21) de la pluralité de moyens d'exploitation électriques (9, 11, 19, 21), on utilise comme évolution attendue de la charge du moyen d'exploitation électrique (9, 11, 19, 21) une évolution attendue de la grandeur caractéristique déterminée selon la revendication 2 ou selon l'une des revendications 4 à 7, dans la mesure où elle dépend de la revendication 2, pour ledit au moins un moyen d'exploitation électrique (9, 11, 19, 21).

9. Procédé de gestion d'un moyen d'exploitation électrique (9, 11, 19, 21), dans lequel une charge électrique du moyen d'exploitation électrique (9, 11, 19, 21) est adaptée à un moment de détermination en tenant compte de la grandeur caractéristique déterminée pour le moment de détermination selon l'une des revendications 1 à 7.

10. Système de détermination d'une grandeur caractéristique pour représenter une charge thermique d'un équipement électrique (9, 11, 19, 21) pour un instant de détermination, le système comprenant un dispositif de traitement de données (23) configuré pour mettre en oeuvre un procédé selon l'une quelconque des revendications 1 à 7.

11. Système de calcul de sécurité de réseau dans un réseau électrique comprenant une pluralité de ressources électriques (9, 11, 19, 21), le système comprenant un dispositif de traitement de données (23) configuré pour exécuter un procédé selon la revendication 8.

12. Système de gestion du fonctionnement d'un équipement électrique (9, 11, 19, 21), le système comprenant une unité de traitement de données (23) configurée pour mettre en oeuvre un procédé selon la revendication 9.
